Europäisches Patentamt

European Patent Office

Office européen des brevets

(19)

(11) EP 0 603 048 B1

(12) **FASCICULE DE BREVET EUROPEEN**

(45) Date de publication et mention
de la délivrance du brevet:
**20.03.1996 Bulletin 1996/12**

(51) Int Cl.⁶: **H05K 7/20**, F28D 15/02

(21) Numéro de dépôt: **93403004.0**

(22) Date de dépôt: **13.12.1993**

(54) **Système de dissipation de l'énergie calorifique dégagée par un composant électronique et enceinte close utilisée dans un tel système**

System zur Wärmeabführung für ein elektronisches Bauelement und ein geschlossenes Gehäuse in einem solchen System

Heat dissipation system for an electronic component and a hermetically sealed casing in such a system

(84) Etats contractants désignés:
**DE ES FR GB IT NL SE**

(30) Priorité: **16.12.1992 FR 9215166**

(43) Date de publication de la demande:
**22.06.1994 Bulletin 1994/25**

(73) Titulaire: **ALCATEL TELSPACE**
**F-92734 Nanterre Cédex (FR)**

(72) Inventeurs:
• **Brunet, Patrice**
**F-92400 Courbevoie (FR)**
• **Avignon, Gilles**
**F95100 Argenteuil (FR)**
• **Heron, Franck**
**F-92160 Antony (FR)**

(74) Mandataire:
**Pothet, Jean Rémy Emile Ludovic et al**
**c/o SOSPI**
**14-16 rue de la Baume**
**F-75008 Paris (FR)**

(56) Documents cités:
**EP-A- 0 298 372**          **EP-A- 0 364 361**
**US-A- 3 517 730**          **US-A- 4 327 399**

## Description

Le domaine de l'invention est celui de la dissipation de l'énergie calorifique dégagée par un composant électronique.

Certains composants électroniques, tels que par exemple les transistors de puissance haute fréquence qui dégagent une importante énergie calorifique, nécessitent des moyens de refroidissement capables de dissiper de façon efficace cette énergie. Ces composants sont habituellement montés sur des dissipateurs thermiques munis d'ailettes de refroidissement.

Le fait de monter directement le composant à refroidir sur un radiateur permet de disposer d'une résistance thermique très faible entre ces deux éléments, mais présente l'inconvénient de limiter l'échange thermique à la surface présentée par la source de chaleur du composant.

On connaît par ailleurs un système de dissipation thermique qui emploie un élément placé entre le composant à refroidir et un dissipateur thermique, cet élément étant appelé caloduc. Un caloduc est un moyen de liaison thermique constitué par un conduit qui contient un fluide présentant la caractéristique de se vaporiser à une température donnée. Tout apport suffisant de chaleur en un point du caloduc provoque la vaporisation d'une petite quantité de ce fluide avec absorption de la chaleur latente de vaporisation. La vapeur formée se déplace dans le conduit et se condense en un point plus froid en restituant la chaleur latente. L'enceinte comporte également un réseau capillaire destiné à permettre un retour du condensat vers le composant.

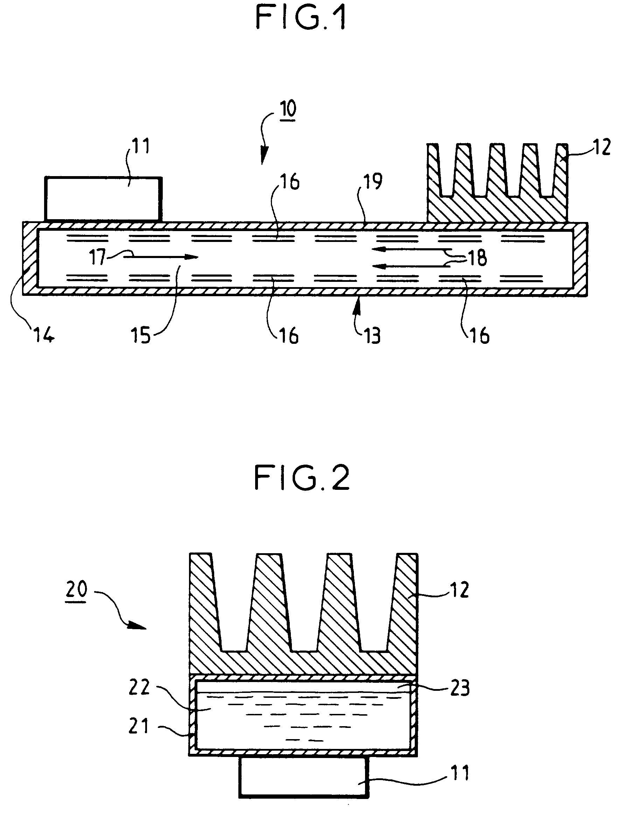

La figure 1 est une vue en coupe schématique d'un tel système de dissipation.

Un système 10 de dissipation à caloduc comporte un composant électronique 11 dont on veut limiter l'échauffement, un dissipateur thermique 12, constitué par un radiateur à ailettes, et un caloduc 13 placé entre le composant 11 et le dissipateur 12. Le composant 11 et le dissipateur 12 sont fixés sur la même paroi 19 du caloduc 13. Ce caloduc 13 est constitué par une enceinte 14 close comportant un fluide 15 et un réseau capillaire 16. Lorsque le composant 11 s'échauffe au dessus de la température de vaporisation du fluide 15, celui-ci vaporise et la vapeur résultante se dirige vers une zone de température plus froide selon un sens 17. Au niveau du dissipateur 12, cette vapeur repasse à l'état de fluide qui progresse en direction de la zone chaude par l'intermédiaire du réseau capillaire 16, selon un sens 18.

Un tel caloduc présente une résistance thermique très faible, ce qui favorise le contact thermique entre le composant 11 et le dissipateur 12, mais son principal inconvénient est qu'il suppose de constamment maintenir le composant 11 à une température supérieure à celle de la température ambiante maximale prévue. En effet, un système de dissipation à caloduc est caractérisé par un point de fonctionnement à température fixe située au-dessus de la température ambiante maximale.

A titre d'exemple, en utilisation externe, pendant les saisons chaudes où la température ambiante peut atteindre 55°C, il est nécessaire d'utiliser un fluide dont la température de changement de phase (fluide-vapeur) est supérieure à 55°C, par exemple égale à 60°C. Dans ce cas, pour que le caloduc 13 puisse fonctionner quelle que soit la température ambiante, il est nécessaire de maintenir pendant toute l'année le composant 11 à une température de fonctionnement telle que sa température de semelle soit supérieure à 60°C, par exemple à 65°C. Si la semelle du composant 11 doit être maintenue à une telle température, la température de sa jonction est bien supérieure, à environ 150°C, et une destruction rapide du composant peut en résulter. Un fonctionnement artificiel à cette température de semelle minimale entraîne une diminution de la durée de vie du composant.

De plus, un système de dissipation à caloduc présente un encombrement non négligeable du fait qu'il est nécessaire d'éloigner suffisamment le composant du dissipateur thermique, afin de permettre une condensation du fluide en phase vapeur.

On connaît également, par le document EP-A-0.298.372 au nom de HITACHI, un dispositif de refroidissement de semi-conducteurs. Ce dispositif comporte un boîtier fermé comportant un liquide à changement de phase ($C_6F_{14}$) et des composants semi-conducteurs. Lors de l'échauffement de ces composants, le liquide en phase vapeur monte pour se condenser et retombe ensuite sous forme liquide. Des conduites sont prévues pour séparer les flux montant et descendant. Le boîtier ne comporte qu'un élément, présent en phase liquide et phase vapeur.

Par ailleurs, le document US-A-4.327.399 au nom de SASAKI et al. décrit un système de refroidissement de composants électroniques montés sur un circuit imprimé. Une face des composants est en contact avec un fluide présent dans une enceinte close. Ce document fait également apparaître que l'enceinte comporte uniquement un fluide, en équilibre entre sa phase liquide et sa phase vapeur.

La présente invention a notamment pour objectif de pallier ces inconvénients en fournissant un système de dissipation de l'énergie calorifique dégagée par un composant électronique à très faible résistance thermique, qui ne nécessite pas de faire fonctionner le composant à refroidir au-dessus d'une température minimale donnée.

Un autre objectif est de limiter l'encombrement d'un tel système de dissipation.

Un objectif complémentaire est de fournir une enceinte utilisée dans un tel système, cette enceinte étant destinée à assurer la jonction entre un dissipateur thermique et un composant à refroidir.

Ces objectifs, ainsi que d'autres qui apparaîtront par la suite, sont atteints grâce à un système de dissipation de l'énergie calorifique dégagée par un composant électronique, du type comprenant une enceinte métallique close dont le volume intérieur comporte un fluide, le composant étant fixé en paroi externe de cette enceinte et relié à un dissipateur thermique par l'intermédiaire de cette enceinte, ce système étant caractérisé en ce que la température de changement de phase du fluide à la pression atmosphérique est inférieure à une température ambiante maximale donnée et en ce que l'enceinte comporte également un volume de gaz différent du fluide de telle sorte qu'une variation de la température ambiante entraîne une variation de pression à l'intérieur de l'enceinte qui modifie la température de changement de phase du fluide.

On obtient ainsi une variation de la pression partielle du gaz à l'intérieur de l'enceinte en fonction de la variation de volume offert qui dépend de la température ambiante.

Avantageusement, l'enceinte comporte deux parois sensiblement parallèles et le composant et le dissipateur sont chacun fixés à une des parois.

L'enceinte est alors prise en sandwich entre le composant et le dissipateur et l'encombrement global est bien plus faible qu'avec un système à caloduc.

Dans un autre mode de réalisation, le composant et le dissipateur sont fixés sur une même paroi de l'enceinte.

Préférentiellement, l'enceinte comporte au moins une zone de concentration de gaz sous pression non remplie du fluide lorsque la température ambiante est inférieure à la température ambiante maximale, cette zone permettant au fluide de mettre en contact thermique le composant et le dissipateur.

Dans un mode de réalisation préférentiel, le composant est un transistor hyperfréquence monté dans un boîtier de blindage électromagnétique.

Avantageusement, le rapport de remplissage de l'enceinte par le fluide est égal à:

$$\frac{V_0}{v_0} = \frac{1}{\beta} \cdot [\frac{1}{\Delta T} - \frac{P_0}{P_i \cdot \Delta T} - \frac{P_0}{P_i T_0}]$$

avec

$v_0 = v_i + v_0 . \beta . \Delta T$ où:

- $V_0$ est le volume de fluide utilisé;
- $v_0$ est le volume résiduel de gaz à l'intérieur de l'enceinte aux conditions initiales;
- $\beta$ est le coefficient de dilatation du fluide;
- $\Delta T = T_i - T_0$ où $T_i$ est la température ambiante maximale et $T_0$ la température de remplissage de l'enceinte;
- $P_0$ est la pression ambiante lors du remplissage de l'enceinte;
- $P_i$ est la pression à l'intérieur de l'enceinte à la température $T_i$;
- $v_i$ est le volume de gaz enfermé dans l'enceinte à la pression $P_i$.

Préférentiellement, le gaz utilisé est de l'air.

L'invention concerne également une enceinte close utilisée dans un tel système.

D'autres caractéristiques et avantages de l'invention apparaîtront à la lecture de la description suivante de plusieurs modes de réalisation préférentiels, donnés à titre illustratif et non limitatif, et des dessins annexés dans lesquels:

- la figure 1 est une vue en coupe schématique d'un système connu de dissipation de l'énergie calorifique dégagée par un composant électronique;
- les figures 2, 3 et 4 sont des vues en coupe schématiques de trois modes de réalisation préférentiels de la présente invention;
- la figure 5 représente l'évolution de la température de semelle d'un composant en fonction de la température ambiante, pour des systèmes de refroidissement du type représentés aux figures 2 et 3.

La figure 1 concernant un système de dissipation à caloduc a été décrite précédemment en référence à l'état de la technique. Comme indiqué, ce système présente l'avantage de maintenir un composant à une température sensiblement constante quelle que soit la température ambiante, mais a l'inconvénient de maintenir en permanence le composant à refroidir à une température supérieure à la température ambiante prévue.

La présente invention propose d'utiliser un système de dissipation faisant intervenir un élément qui se distingue d'un système à caloduc en ce qu'il permet d'asservir la température de changement de phase d'un fluide compris dans une enceinte close à la température ambiante. Ainsi, une augmentation de la température ambiante a pour effet d'augmenter la température de changement de phase du fluide, ce qui implique un point d'ébullition situé plus haut en température. On utilise pour cela un fluide présentant une température de changement de phase à pression atmosphérique faible, par exemple de l'ordre de 30°C, associé à un gaz, par exemple de l'air. Cette température de changement de phase est appelée température nominale de changement de phase. Un tel fluide est par exemple vendu par la société 3M sous la marque Fluorinert (marques déposées) et sa référence est FC 87.

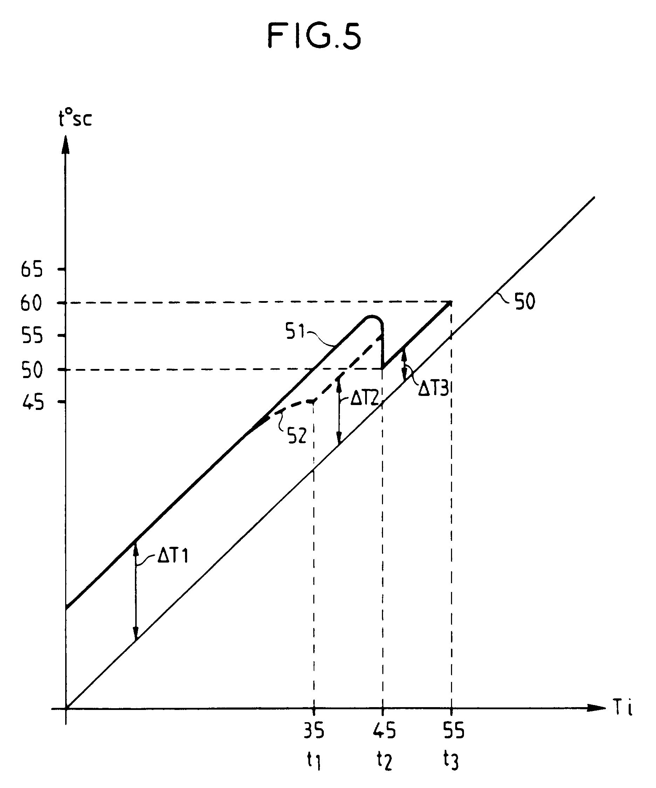

Ce fluide est introduit dans une enceinte métallique close et des paramètres, tels que le taux de remplissage de l'enceinte et la température à laquelle le fluide est introduit, sont optimisés en fonction de la pression atmosphérique de telle sorte que la température de changement de phase "suive" la température ambiante, comme il sera décrit plus précisément en référence à la figure 5.

La figure 2 qui est une vue en coupe schématique d'un premier mode de réalisation préférentiel de l'invention.

Sur cette figure, le système 20 de dissipation de l'énergie calorifique dégagée par un composant 11 comporte une enceinte 21 close dont le volume intérieur comporte un fluide 22 apte à changer de phase lorsqu'une énergie thermique lui est communiquée, de même que dans l'état de la technique précité. Le composant 11 est placé contre une paroi de l'enceinte 21 et relié à un dissipateur thermique 12 par l'intermédiaire de cette enceinte 21. Les moyens de fixation du composant et du dissipateur à l'enceinte 21 ne sont pas représentés et ne rentrent pas dans le cadre de l'invention. L'enceinte 21 comprend également un volume libre 23, par exemple rempli d'air ou d'un autre gaz différent du fluide utilisé, permettant une augmentation de la pression à l'intérieur de l'enceinte 21 par dilatation du fluide 22. Cette dilatation est obtenue lorsque la température ambiante augmente et provoque une augmentation de pression partielle à l'intérieur de l'enceinte 21. Cette pression partielle est due à la présence du gaz dans l'enceinte 21. Ce volume libre est obtenu lors du remplissage de l'enceinte 21 par le fluide 22. La dilatation du fluide 22, provoquée par une augmentation de température ambiante, permet de diminuer la résistance thermique présentée par l'enceinte 21, entre le composant 11 et le dissipateur 12, comme il sera vu par la suite.

Le FC 87 est caractérisé par une température de changement de phase nominale d'environ 30°C et présente une pression de vapeur $P_i$ (pression de vapeur saturante) augmentant avec la température ambiante $T_i$ selon la formule de Clapeyron :

$$\text{Log } P_i \text{ (mm Hg)} = A - \frac{B}{T_i(°K)}$$

avec A = 7,9768 et B = 1548. Les valeurs de A et B, constantes caractéristiques du fluide, varient en fonction du fluide utilisé et sont données par le fabricant. D'autres fluides présentant une température de changement de phase faible à la pression atmosphérique peuvent également être utilisés.

Si l'on note $P_0$ la pression ambiante lors du remplissage partiel de l'enceinte 21 par le fluide 22, $T_0$ la température à laquelle ce remplissage a lieu, $V_0$ le volume de fluide 22 utilisé et $v_0$ le volume d'air (ou d'un autre gaz) à l'intérieur de l'enceinte, on peut déterminer par calcul le rapport $V_0/v_0$ optimal permettant d'asservir le mieux possible la température du composant à la température ambiante. Pour cela, en connaissant pour un fluide donné son coefficient de dilatation $\beta$ (en $cm^3/(cm^3)(°C)$) (le coefficient $\beta$ du FC 87 valant $1,6.10^{-3}$) et en résolvant l'équation:

$$\frac{P_0 v_0}{T_0} = \frac{P_i v_i}{T_0}$$

avec $v_i = v_0 - V_0.\beta.\Delta T$, $v_i$ étant le volume d'air enfermé après remplissage à la pression $P_i$, et où $\Delta T = T_i - T_0$, on obtient:

$$\frac{V_0}{v_0} = \frac{1}{\beta}.[\frac{1}{\Delta T} - \frac{P_0}{P_i.\Delta T} - \frac{P_0}{P_i T_0}]$$

En résolvant cette équation on trouve le rapport de remplissage $V_0/v_0$ optimal permettant d'obtenir une enceinte dont la température de changement de phase du fluide suit celle de la température ambiante.

Les rapports de remplissage $V_0/v_0$ du tableau suivant ont été calculés pour le FC 87 en considérant une température de remplissage $(T_0)$ de 20°C à la pression atmosphérique $(P_0)$, le gaz utilisé étant de l'air à 20°C:

| $T_i(°C)$ | 35 | 40 | 45 | 50 | 55 | 60 | 65 |
|---|---|---|---|---|---|---|---|
| $P_i(Pa)$ | 1,175 | 1,41 | 1,69 | 2,01 | 2,38 | 2,80 | 3,28 |
| $V_0/v_0$ | 4,4 | 7,6 | 8,9 | 9,4 | 9,5 | 9,3 | 9 |

On constate que pour un rapport de remplissage $V_0/v_0$ de l'enceinte de 9,5 à une température ambiante de 20°C, la température ambiante, lors de l'utilisation du système de dissipation, peut varier entre 45 et 55°C tout en conservant une température de changement de phase asservie à cette température ambiante, c'est à dire 50 et 60°C, cette différence de température correspondant à la résistance thermique Rth mécanique résiduelle entre la semelle du composant et le fluide (estimée à 5°C). Si on avait choisi un rapport de remplissage de 8,9 seulement, il n'y aurait pas eu assez de fluide à l'intérieur de l'enceinte et, pour une température ambiante de 50°C, le fluide ne se serait pas suffisamment dilaté. En conséquence, l'augmentation de pression n'aurait pas été suffisante et il n'y aurait pas eu de condensation du fluide, d'où un refroidissement insuffisant du composant.

Le fonctionnement d'un tel système de dissipation est décrit en référence à la figure 5. La caractéristique 51 de cette figure représente l'évolution de température (t°sc) de la semelle du composant 11 en fonction de la température ambiante ($T_i$). La bissectrice 50 représente l'évolution de la température ambiante et t3 la température ambiante maximale choisie (55°C).

Tant que la température ambiante est inférieure à t2 (45°C), le composant 11 est essentiellement refroidi par conduction de l'énergie calorifique qu'il dégage par l'intermédiaire du corps de l'enceinte 21. Le fluide 22 intervient peu dans l'établissement d'un contact thermique entre le composant 11 et le dissipateur 12. Lorsque la température ambiante approche de t2, le fluide 22 se dilate quelque peu et on assiste à une augmentation de la pression partielle due à la présence d'air dans l'enceinte et la caractéristique 51 commence à s'infléchir. Lorsque t2 est atteint, le fluide 22 se vaporise et la température de la semelle chute rapidement. La différence de température ΔT3, de l'ordre de 5°C, entre la semelle et l'ambiante est due à la résistance thermique résiduelle due aux connexions mécaniques entre le composant 11 et le dissipateur 12. Au-delà de t2, la température de la semelle du composant 11 suit la température ambiante, l'écart ΔT3 restant constant.

Ainsi, l'augmentation de pression à l'intérieur de l'enceinte modifie la température de changement de phase du fluide de telle sorte que la température de la semelle du composant suive la température ambiante, à un ΔT3 près. Dans ce mode de réalisation, le fluide 22 n'entre pas en contact avec la paroi contre laquelle le dissipateur 12 est fixé car la couche d'air constituant le volume de gaz libre optimisé lors du remplissage de l'enceinte par le fluide l'en empêche.

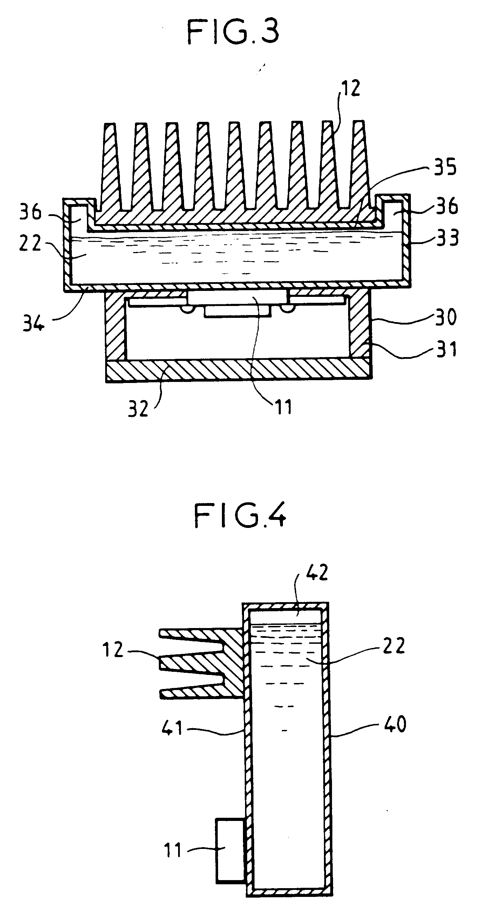

La figure 3 représente un deuxième mode de réalisation d'un système de dissipation selon l'invention.

Le composant 11 est ici un transistor hyperfréquence monté dans un boîtier 30 de blindage électromagnétique constitué par un socle 31 recouvert par un couvercle 32.

Le socle 30 renferme un substrat sur lequel sont réalisées des pistes conductrices d'électricité, formant des lignes micro-ruban. Ces lignes micro-ruban sont raccordées au composant 11 par des points de soudure. Le substrat est habituellement un mélange de verre et de Téflon et le composant 11 est fixé dans une encoche réalisée dans le socle 30, généralement par collage ou par vissage. L'encoche permet d'appliquer le composant 11 contre une enceinte 33 renfermant le fluide 22. Cette enceinte 33 comporte deux parois 34, 35 sensiblement parallèles et le composant 11 et le dissipateur 12 sont chacun fixés à une des parois. L'enceinte 33 comporte également deux épaulements 36, ici situés du côté du dissipateur 12, formant des zones de concentration d'air sous pression, dont la fonction sera décrite dans la description suivante de la caractéristique 52 de la figure 5.

On peut distinguer trois états de fonctionnement d'un dispositif tel que représenté à la figure 3 : dans un premier état de fonctionnement, la température ambiante est basse et très inférieure à la température de changement de phase nominale, par exemple à 10°C (pour une température de changement de phase de 30°C à la pression atmosphérique), la résistance thermique entre le composant 11 et le dissipateur 12 est celle présentée par le corps de l'enceinte, le fluide 22 intervenant peu puisqu'il n'est pas en contact avec la paroi supérieure de l'enceinte contre laquelle le composant est fixé. Cette différence de température est la même que celle précédemment indiquée pour la caractéristique 51 et vaut ΔT1, de l'ordre de 15°C. Lorsque la température ambiante augmente et atteint une température tl inférieure à la température de changement de phase, de l'ordre de 35°C par exemple, le fluide 22 s'est dilaté suffisamment pour entrer en contact avec la paroi 35 contre laquelle le dissipateur 12 est fixé et recouvrir la surface présentée par le dissipateur. La résistance thermique présentée entre le composant 11 et le dissipateur 12 est sensiblement celle du fluide 22. Cette résistance thermique est très faible pour un fluide tel que le FC 87, de l'ordre de 5,5 à 7,2 W/cm°K. La différence de température ΔT2 dépend de la conduction par le fluide à l'état liquide et vaut par exemple 10°C. L'air présent dans l'enceinte 33 est alors comprimé dans les épaulements 36. Ceci correspond à la deuxième étape de fonctionnement. Dans la troisième étape, la température ambiante dépasse la température de changement de phase prévue et il n'existe pas de différence de température entre la semelle du composant 11 et le dissipateur 12. La résistance thermique est alors uniquement due à la mécanique employée et on observe la différence de température ΔT3. Ce phénomène se poursuit sur une large plage de température et la caractéristique 52 se confond alors avec la caractéristique 51.

A titre d'exemple, pour le fluide susmentionné et un volume occupé à 20°C de 90% du volume total de l'enceinte, la pression $P_i$ vaut 1,28 bars pour une température ambiante de 33°C et 3,28 bars pour une température ambiante de 65°C.

Il est à noter que les structures des systèmes de dissipation des figures 2 et 3 permettent d'obtenir un cône de dissipation thermique optimal puisque la source de chaleur du composant est en contact thermique avec la totalité de la semelle du dissipateur. Un cône de dissipation correspond à la conduction de l'énergie calorifique à l'intérieur de l'enceinte, en direction du dissipateur. La surface supérieure de ce cône correspond à celle de la jonction du composant, cette jonction étant le siège de la source de chaleur.

La figure 4 représente un troisième mode de réalisation du système de dissipation de l'invention.

Sur cette figure, le composant 11 est fixé sur la même paroi d'enceinte que le dissipateur 12. Cette paroi est référencée 41 et l'enceinte 40. Le dissipateur 12 est disposé au-dessus du composant 11 et l'enceinte 40 est donc dans une position verticale. De même que dans la figure 3, l'enceinte 40 comporte une zone 42 qui est destinée à être remplie d'air sous pression lorsque la température ambiante provoque une dilatation du fluide.

D'autres modes de réalisation sont bien entendu possibles et la forme de l'enceinte et les dispositions des zones d'air peuvent notamment être adaptées aux besoins. Il est également possible de remplacer l'air par un autre gaz, l'essentiel étant qu'une dilatation du fluide entraîne une augmentation de pression à l'intérieur de l'enceinte, cette pression correspondant à la pression partielle due à ce gaz.

Le principal avantage de l'invention est que le composant à refroidir est sensiblement maintenu à la température ambiante et que, lorsque la température ambiante est faible, le composant n'est pas refroidi à l'aide du fluide de l'enceinte mais uniquement par les pièces métalliques utilisées (corps de l'enceinte servant de drain thermique). En revanche, lorsque la température ambiante augmente, le composant est ramené à cette température ambiante (à ΔT3 près). En conséquence, on vise à garder le composant dans une gamme de température relativement petite, c'est à dire que ses caractéristiques de fonctionnement seront conservées. Il est en effet souhaitable de ne pas modifier la température du composant pour qu'elle suive la température ambiante lorsque cette température ambiante est faible.

Dans un système de refroidissement à caloduc, l'enceinte ne contient que le fluide assurant un transfert de chaleur et le point de fonctionnement est donc uniquement lié à la formule de Clapeyron puisque la dilatation de ce fluide, liée à l'augmentation de la température ambiante, ne crée pas d'augmentation de pression et ne modifie donc pas la température de changement de phase. Dans un caloduc, une fois que le fluide est introduit, un pompage de l'air introduit lors de cette introduction est réalisé, de telle sorte que la pression à l'intérieur du caloduc soit égale à la pression de vapeur saturante et il n'y a donc que le fluide dans le caloduc.

Au contraire, l'invention utilise une enceinte close comprenant un volume de gaz différent du fluide utilisé, le volume de fluide étant significatif. Ainsi, la dilatation du fluide s'ajoute aux effets de la loi de Clapeyron et permet d'obtenir un asservissement de la température de changement de phase du fluide à la température ambiante.

Le système de l'invention allie efficacité, faible coût et compacité et il est également possible de fixer plusieurs composants à refroidir sur une même enceinte. On peut aussi réaliser une telle enceinte faisant corps avec le dissipateur thermique et/ou avec un boîtier de blindage tel que représenté à la figure 3.

## Revendications

1. Système de dissipation de l'énergie calorifique dégagée par un composant électronique, le système étant du type comprenant une enceinte (21, 33, 40) métallique close dont le volume intérieur comporte un fluide (22), ledit composant (11) étant fixé en paroi externe de ladite enceinte (21, 33, 40) et relié à un dissipateur thermique (12) par l'intermédiaire de cette enceinte (21, 33, 40),

   caractérisé en ce que la température de changement de phase dudit fluide (22) à la pression atmosphérique est inférieure à une température ambiante maximale (t2) donnée et en ce que ladite enceinte (21, 33, 40) comporte également un volume de gaz (23, 36, 42) différent dudit fluide (22) de telle sorte qu'une variation de la température ambiante entraîne une variation de pression à l'intérieur de ladite enceinte (21, 33, 40) qui modifie la température de changement de phase dudit fluide (22).

2. Système selon la revendication 1, caractérisé en ce que ladite enceinte (21, 33) comporte deux parois (34, 35) sensiblement parallèles et en ce que ledit composant (11) et ledit dissipateur (12) sont chacun fixés à une desdites parois (34, 35).

3. Système selon la revendication 1, caractérisé en ce que ledit composant (11) et ledit dissipateur (12) sont fixés sur une même paroi (41) de ladite enceinte (40).

4. Système selon l'une des revendications 1 à 3, caractérisé en ce que ladite enceinte (40) comporte au moins une zone (36, 42) de concentration de gaz sous pression non remplie dudit fluide (22) lorsque la température ambiante est inférieure à ladite température ambiante maximale, ladite zone (36, 42) permettant audit fluide (22) de mettre en contact thermique ledit composant (11) et ledit dissipateur (12).

5. Système selon l'une des revendications 1 à 4, caractérisé en ce que ledit composant (11) est un transistor hyperfréquence monté dans un boîtier (30) de blindage électromagnétique.

6. Système selon l'une des revendications 1 à 5, caractérisé en ce que le rapport de remplissage de ladite enceinte (21, 33, 40) par ledit fluide (22) est égal à:

$$\frac{V_0}{V_0} = \frac{1}{\beta} \cdot \left[ \frac{1}{\Delta T} - \frac{P_0}{P_i \cdot \Delta T} - \frac{P_0}{P_i T_0} \right]$$

avec

$$v_0 = v_i + V_0.\beta.\Delta T$$

où:

- V0 est le volume de fluide (22) utilisé;
- $v_0$ est le volume résiduel de gaz à l'intérieur de ladite enceinte (21, 33, 40) aux conditions initiales;
- $\beta$ est le coefficient de dilatation dudit fluide (22);
- $\Delta T = T_i\text{-}T_0$ où $T_i$ est la température ambiante maximale et $T_0$ la température de remplissage de ladite enceinte (21, 33, 40);
- $P_0$ est la pression ambiante lors du remplissage de ladite enceinte (21, 33, 40);
- $P_i$ est la pression à l'intérieur de ladite enceinte (21, 33, 40) à la température $T_i$;
- $v_i$ est le volume de gaz enfermé dans ladite enceinte (21, 33, 40) à ladite pression $P_i$.

7. Système selon l'une des revendications 1 à 6, caractérisé en ce que ledit gaz est de l'air.

8. Enceinte métallique close dont le volume intérieur comporte un fluide (22), caractérisée en ce que la température de changement de phase dudit fluide (22) à la pression atmosphérique est inférieure à une température ambiante maximale (t2) donnée et en ce que ladite enceinte (21, 33, 40) comporte également un volume de gaz (23, 36, 42) différent dudit fluide (22) de telle sorte qu'une variation de la température ambiante entraîne une variation de pression à l'intérieur de ladite enceinte (21, 33, 40) qui modifie la température de changement de phase dudit fluide (22).

9. Enceinte selon la revendication 8, caractérisée en ce qu'elle comporte au moins une zone (36, 42) de concentration de gaz sous pression non remplie dudit fluide (22) lorsque la température ambiante est inférieure à ladite température ambiante maximale, ladite zone (36, 42) permettant audit fluide (22) de mettre en contact thermique un composant électronique (11) avec un dissipateur thermique (12).

10. Enceinte selon l'une des revendications 8 et 9, caractérisée en ce que le rapport de remplissage de ladite enceinte (21, 33, 40) par ledit fluide (22) est égal à:

$$\frac{V_0}{V_0} = \frac{1}{\beta}.[\frac{1}{\Delta T} - \frac{P_0}{P_i.\Delta T} - \frac{P_0}{P_iT_0}]$$

avec

$$v_0 = v_i + V_0.\beta.\Delta T \text{ où:}$$

- V0 est le volume de fluide (22) utilisé;
- $v_0$ est le volume résiduel de gaz à l'intérieur de ladite enceinte (21, 33, 40) aux conditions initiales;
- $\beta$ est le coefficient de dilatation dudit fluide (22);
- $\Delta T = T_i\text{-}T_0$ où $T_i$ est la température ambiante maximale et $T_0$ la température de remplissage de ladite enceinte (21, 33, 40);
- $P_0$ est la pression ambiante lors du remplissage de ladite enceinte (21, 33, 40);
- $P_i$ est la pression à l'intérieur de ladite enceinte (21, 33, 40) à la température $T_i$;
- $v_i$ est le volume de gaz enfermé dans ladite enceinte (21, 33, 40) à ladite pression $P_i$.

11. Enceinte selon l'une des revendications 8 à 10, caractérisée en ce que ledit gaz est de l'air.

**Patentansprüche**

1. System zur Abfuhr von Wärme, die von einem elektronischen Bauelement abgegeben wird, wobei das System einen ein Fluid (22) enthaltenden geschlossenen Metallbehälter (21, 33, 40) aufweist und das Bauelement (11) an der Außenwand des Behälters (21, 33, 40) befestigt und mit einem Wärmeabfuhrorgan (12) über diesen Behälter (21, 33, 40) verbunden ist,
dadurch gekennzeichnet, daß die Phasenwechseltemperatur des Fluids (22) bei Atmosphärendruck niedriger als eine gegebene maximale Umgebungstemperatur (t2) ist und daß der Behälter (21, 33, 40) weiter ein Volumen eines sich vom Fluid (22) unterscheidenden Gases (23, 36, 42) enthält, derart, daß eine Veränderung der Umgebungstemperatur zu einer Veränderung des Drucks im Inneren des Behälters (21, 33, 40) führt, wodurch die Phasenwechseltemperatur des Fluids (22) verändert wird.

2. System nach Anspruch 1, dadurch gekennzeichnet, daß der Behälter (21, 33) zwei im wesentlichen parallele Wände (34, 35) besitzt und daß das Bauelement (11) sowie das Wärmeabfuhrorgan (12) je an einer dieser Wände (34, 35) befestigt sind.

3. System nach Anspruch 1, dadurch gekennzeichnet, daß das Bauelement (11) und das Wärmeabfuhrorgan (12) an einer gemeinsamen Wand (41) des Behälters (40) befestigt sind.

4. System nach einem der Ansprüche 1 bis 3, dadurch gekennzeichnet, daß der Behälter (40) mindestens eine Zone (36, 42) aufweist, in der sich das nicht mit Fluid (22) besetzte Volumen von unter Druck stehendem Gas konzentriert, wenn die Umgebungstemperatur unter der maximalen Umgebungstemperatur liegt, wobei aufgrund dieser Zone (36, 42) das Bauelement (11) und das Wärmeabfuhrorgan (12) über das Fluid (2) in Wärmekontakt gelangen.

5. System nach einem der Ansprüche 1 bis 4, dadurch gekennzeichnet, daß das Bauelement (11) ein Mikrowellentransistor ist, der in einem als elektromagnetische Abschirmung wirkenden Gehäuse (30) montiert ist.

6. System nach einem der Ansprüche 1 bis 5, dadurch gekennzeichnet, daß der Füllungsgrad des Behälters (21, 33, 40) mit dem Fluid (22) folgender Formel entspricht:

$$V_0/v_0 = 1/\beta \cdot (1/\Delta T - P_0/P_i \cdot \Delta T - P_0/P_i T_0)$$

mit

$$v_0 = v_i + v_0 \cdot \beta \cdot \Delta T; \text{ hierbei ist:}$$

- $V_0$ das verwendete Fluidvolumen (22),
- $v_0$ das verbleibende Gasvolumen im Inneren des Behälters (21, 33, 40) bei den Anfangsbedingungen,
- $\beta$ der Ausdehnungskoeffizient des Fluids (22),
- $\Delta T = T_i - T_0$, wobei $T_i$ die maximale Umgebungstemperatur und $T_0$ die Temperatur ist, bei der der Behälter (21, 33, 40) gefüllt wird,
- $P_0$ der Umgebungsdruck beim Füllen des Behälters (21, 33, 40),
- $P_i$ der Druck im Inneren des Behälters (21, 33, 40) bei der Temperatur $T_i$,
- $v_i$ das Gasvolumen im Behälter (21, 33, 40) beim Druck $P_i$.

7. System nach einem der Ansprüche 1 bis 6, dadurch gekennzeichnet, daß das verwendete Gas Luft ist.

8. Verschlossener Metallbehälter, dessen Innenvolumen ein Fluid (22) enthält, dadurch gekennzeichnet, daß die Phasenwechseltemperatur des Fluids (22) bei Atmosphärendruck unter einer gegebenen maximalen Umgebungstemperatur (t2) liegt und daß der Behälter (21, 33, 40) weiter ein Volumen (23, 36, 42) sich von dem Fluid (22) unterscheidenden Gases enthält, derart, daß eine Veränderung der Umgebungstemperatur zu einer Veränderung des Drucks im Inneren des Behälters (21, 33, 40) führt, die wiederum die Phasenwechseltemperatur des Fluids (22) verändert.

9. Behälter nach Anspruch 8, dadurch gekennzeichnet, daß er mindestens eine Zone (36, 42) besitzt, in der sich das nicht mit dem Fluid (22) gefüllte Volumen des unter Druck stehenden Gases konzentriert, wenn die Umgebungstemperatur unter der maximalen Umgebungstemperatur liegt, so daß aufgrund dieser Zone (36, 42) das elektronische Bauelement (11) und ein Wärmeabfuhrorgan (12) über das Fluid (22) in Kontakt gelangen.

10. Behälter nach einem der Ansprüche 8 bis 9, dadurch gekennzeichnet, daß der Füllungsgrad des Behälters (21, 33, 40) mit dem Fluid (22) folgender Formel entspricht:

$$V_0/v_0 = 1/\beta \cdot (1/\Delta T - P_0/P_i \Delta T - P_0/P_i T_0)$$

mit

$$v_0 = v_i + v_0 \cdot \beta \cdot \Delta T$$
hierbei ist:

- $V_0$ das verwendete Fluidvolumen (22),
- $v_0$ das verbleibende Gasvolumen im Inneren des Behälters (21, 33, 40) bei den Anfangsbedingungen,
- $\beta$ der Ausdehnungskoeffizient des Fluids (22),
- $\Delta T = T_i - T_0$, wobei $T_i$ die maximale Umgebungstemperatur und $T_0$ die Temperatur ist, bei der der Behälter (21, 33, 40) gefüllt wird,
- $P_0$ der Umgebungsdruck beim Füllen des Behälters (21, 33, 40),

- $P_i$ der Druck im Inneren des Behälters (21, 33, 40) bei der Temperatur $T_i$,
- $v_i$ das Gasvolumen im Behälter (21, 33, 40) beim Druck $P_i$.

11. Behälter nach einem der Ansprüche 1 bis 10, dadurch gekennzeichnet, daß das Gas Luft ist.

**Claims**

1. System for dissipating heat energy generated by an electronic component, the system being of the type comprising a sealed metal enclosure (21, 33, 40) the interior volume of which contains a fluid (22), said component (11) being fixed to the outside wall of said enclosure (21, 33, 40) and connected to a heat dissipator (12) by said enclosure (21, 33, 40),
characterized in that the phase change temperature of said fluid (22) at atmospheric pressure is less than a given maximum ambient temperature (t2) and in that said enclosure (21, 33, 40) also contains a volume of gas (23, 36, 42) different from said fluid (22) so that variation in the ambient temperature causes a variation in the pressure inside said enclosure (21, 33, 40) which modifies the phase change temperature of said fluid (22).

2. System according to claim 1 characterized in that said enclosure (21, 33) has two substantially parallel walls (34, 35) and in that said component (11) and said dissipator (12) are each fixed to one of said walls (34, 35).

3. System according to claim 1 characterized in that said component (11) and said dissipator (12) are fixed to the same wall (41) of said enclosure (40).

4. System according to any one of claims 1 to 3 characterized in that said enclosure (40) includes at least one pressurised gas concentration area (36, 42) not filled with said fluid (22) when the ambient temperature is less than said maximum ambient temperature, said area (36, 42) enabling said fluid (22) to establish thermal contact between said component (11) and said dissipator (12).

5. System according to any one of claims 1 to 4 characterized in that said component (11) is a microwave transistor mounted in an electromagnetic shield box (30).

6. System according to any one of claims 1 to 5 characterized in that the ratio by which said enclosure (21, 33, 40) is filled with said fluid (22) is equal to:

$$\frac{V_0}{V_0} = \frac{1}{\beta} \cdot [\frac{1}{\Delta T} - \frac{P_0}{P_i \cdot \Delta T} - \frac{P_0}{P_i T_0}]$$

with

$$v_0 = v_i = V_0.\beta.\Delta T$$
where:

- $V_0$ is the volume of fluid (22) used;
- $v_0$ is the residual volume of gas inside said enclosure (21, 33, 40) under initial conditions;
- $\beta$ is the coefficient of thermal expansion of said fluid (22);
- $\Delta T = T_i - T_0$ where $T_i$ is the maximum ambient temperature and $T_0$ is the temperature at which said enclosure (21, 33, 40) is filled;
- $P_0$ is the ambient pressure when said enclosure (21, 33, 40) is filled;
- $P_i$ is the pressure inside said enclosure (21, 33, 40) at temperature $T_i$;
- $v_i$ is the volume of the gas in said enclosure (21, 33, 40) at said pressure $P_i$.

7. System according to any one of claims 1 to 6 characterized in that said gas is air.

8. Sealed metal enclosure whose interior volume contains a fluid (22) characterized in that the phase change temperature of said fluid (22) at atmospheric pressure is less than a given maximum ambient temperature (t2) and in that said enclosure (21, 33, 40) also contains a volume of gas (23, 36, 42) different from said fluid (22) so that variation in the ambient temperature causes a variation in pressure inside said enclosure (21, 33, 40) which modifies the phase change temperature of said fluid (22).

9. Enclosure according to claim 8 characterized in that it includes at least one pressurised gas concentration area (36, 42) not filled with said fluid (22) when the ambient temperature is less than said maximum ambient temperature, said area (36, 42) enabling said fluid (22) to establish thermal contact between an electronic component (11) and a heat dissipator (12).

10. Enclosure according to claim 8 or claim 9 characterized in that the ratio by which said enclosure (21, 33, 40) is filled with said fluid (22) is equal to:

$$\frac{V_0}{V_0} = \frac{1}{\beta} \cdot [\frac{1}{\Delta T} - \frac{P_0}{P_i \cdot \Delta T} - \frac{P_0}{P_i T_0}]$$

with

$$v_0 = v_i = V_0 . \beta . \Delta T$$

where:

- $V_0$ is the volume of fluid (22) used;
- $v_0$ is the residual volume of gas inside said enclosure (21, 33, 40) under initial conditions;
- $\beta$ is the coefficient of thermal expansions of said fluid (22);
- $\Delta T = T_i - T_0$ where $T_i$ is the maximum ambient temperature and $T_0$ is the temperature at which said enclosure (21, 33, 40) is filled;
- $P_0$ is the ambient pressure when said enclosure (21, 33, 40) is filled;
- $P_i$ is the pressure inside said enclosure (21, 33, 40) at temperature $T_i$;
- $v_i$ is the volume of the gas in said enclosure (21, 33, 40) at said pressure $P_i$.

11. Enclosure according to any one of claims 8 to 10 characterized in that said gas is air.

# FIG.1

# FIG.2

# FIG.3

# FIG.4

# FIG.5